# EUROPÄISCHE PATENTSCHRIFT

(11) **EP 2 870 487 B1**
(45) Veröffentlichungstag und Bekanntmachung des Hinweises auf die Patenterteilung: **27.04.2016**
(21) Anmeldenummer: 12735822.4
(22) Anmeldetag: 03.07.2012
(51) Int. Cl.: G01R 31/08, H02H 3/38, H02H 7/26, H02H 7/28

(54) **ERKENNEN EINER FEHLERRICHTUNG IN MITTELSPANNUNGS-ENERGIEVERSORGUNGSNETZEN**
DETECTION OF A FAULT DIRECTION IN MEDIUM VOLTAGE POWER SUPPLY NETWORKS
DÉTECTION D'UNE DIRECTION DE DÉFAUT DANS DES RÉSEAUX D'ALIMENTATION EN ÉNERGIE MOYENNE TENSION

(43) Veröffentlichungstag der Anmeldung: 13.05.2015
(73) Patentinhaber: Siemens Aktiengesellschaft, 80333 München (DE)
(72) Erfinder: KIRKMAN, Robert, 90518 Altdorf (DE); OPITSCH, Bruno, 90473 Nürnberg (DE)
(86) Internationale Anmeldenummer: PCT/EP2012/062891
(87) Internationale Veröffentlichungsnummer: WO 2014/005619

(56) Entgegenhaltungen:
- EP-A2- 1 388 920
- WO-A1-02/15358

## Beschreibung

Die Erfindung betrifft ein Verfahren zum Erkennen einer Richtung, in der ein Fehler in einem dreiphasigen elektrischen Mittelspannungs-Energieversorgungsnetz bezüglich einer Messstelle in dem Mittelspannungs-Energieversorgungsnetz aufgetreten ist, bei dem von einer Steuereinrichtung eines elektrischen Schutzgerätes zur Erkennung der Richtung des Fehlers sowohl phasenleiterbezogene Strommesswerte als auch phasenleiterbezogene Spannungsmesswerte herangezogen werden, wobei die Strommesswerte an der Messstelle in dem Mittelspannungs-Energieversorgungsnetz erfasst werden. Die Erfindung betrifft außerdem auch ein entsprechend eingerichtetes elektrisches Schutzgerät.

Zum Erkennen der Richtung, in der ein Fehler, wie beispielsweise ein Kurzschluss oder ein Erdschluss, in einem elektrischen Energieversorgungsnetz aufgetreten ist, ist es bekannt, mit einem Schutzgerät an einer Messstelle des Energieversorgungsnetzes Messwerte von Strom- und Spannung zu erfassen und diese zur Bestimmung der Richtung, in der der Fehler bezogen auf die Messstelle liegt, auszuwerten. Konkret ist beispielsweise aus der US 5,572,138 bekannt, die Fehlerrichtung eines auf einer Energieübertragungsleitung aufgetretenen Fehlers bezüglich einer Messstelle anhand von Änderungen hinsichtlich der Phasenspannung verglichen mit Änderungen hinsichtlich von modellierten Phasenspannungen sowie Änderungen der ersten Ableitung von Strommesswerten zu bestimmen. Außerdem ist aus der EP 1 388 920 A2 ein Schutzgerät bekannt, das durch geeigneten Vergleich von phasenbezogenen Spannungsmesswerten und aus phasenbezogenen Strommesswerten berechneten Nullsystemstromwerten eine Erkennung der Fehlerrichtung eines auf einer Übertragungsleitung liegenden Erdschlusses durchführt.

Insbesondere in Mittelspannungs-Energieversorgungsnetzen mit einer - verglichen mit der Situation in Hochspannungsübertragungsnetzen - hohen Anzahl von Schalt- und Transformatorstationen sowie einer vergleichsweise geringen mittleren Leitungslänge zwischen den einzelnen Stationen bestehen Bestrebungen, Schutzsysteme zum Erkennen von Fehlern möglichst kostengünstig auszubilden.

Der Erfindung liegt daher die Aufgabe zugrunde, ein Verfahren sowie ein entsprechendes elektrisches Schutzgerät anzugeben, um die Richtung, in der ein Fehler in einem dreiphasigen elektrischen Mittelspannungs-Energieversorgungsnetz bezüglich einer Messstelle aufgetreten ist, möglichst einfach und damit kostengünstig zu erkennen.

Diese Aufgabe wird hinsichtlich des Verfahrens erfindungsgemäß durch ein Verfahren der eingangs genannten Art gelöst, bei dem die Spannungsmesswerte auf der Niederspannungsseite eines das Mittelspannungs-Energieversorgungsnetz mit einem Niederspannungs-Energieversorgungsnetz verbindenden Transformators erfasst werden.

Der Erfindung liegt die Erkenntnis zugrunde, dass eine Richtungserkennung bezüglich eines Fehlers im Mittelspannungs-Energieversorgungsnetz auch mit auf der Niederspannungsseite des Transformators erfassten Spannungsmesswerten erfolgen kann, so dass eine Erfassung von Spannungsmesswerten auf der Mittelspannungsseite zur Richtungserkennung nicht nötig ist. Der besondere Vorteil des erfindungsgemäßen Verfahrens liegt dementsprechend darin, dass durch die Erfassung der Spannungsmesswerte auf der Niederspannungsseite des Transformators deutlich kostengünstigere Spannungswandler eingesetzt werden können, da auf die teuren Spannungswandler auf der Mittelspannungsseite des Transformators verzichtet werden kann. Die Fehlerrichtung wird von dem Schutzgerät hierbei entweder als "vorwärts", d. h. auf einem bezüglich der Messstelle in Vorwärtsrichtung liegenden Abschnitt des Mittelspannungs-Energieversorgungsnetzes, oder als "rückwärts", d. h. auf einem bezüglich der Messstelle in Rückwärtsrichtung liegenden Abschnitt, erkannt. Anhand der ermittelten Information über die Fehlerrichtung kann durch das Schutzgerät beispielsweise ein entsprechendes Signal erzeugt werden, das die Fehlerrichtung angibt und das zur Ansteuerung eines Schalters verwendet werden kann, um den Abschnitt, auf dem der Fehler aufgetreten ist, abzuschalten.

Unter dem Begriff "Schutzgerät" soll im Zusammenhang mit der vorliegend beschriebenen Erfindung jegliche Form von intelligenten Mess-, Steuer-, Überwachungs- und/oder Automatisierungsgeräten verstanden werden, die dazu eingerichtet sind, eine Auswertung einer Fehlerrichtung vornehmen können. Hierzu zählen sämtliche sogenannte IEDs (Intelligent Electronic Devices), wie sie im Energieautomatisierungsumfeld eingesetzt werden, insbesondere sollen hierunter neben komplexen Schutzgeräten, wie sie z.B. aus der SIPROTEC-Gerätefamilie der Anmelderin bekannt sind, auch vergleichsweise einfache - und damit kostengünstigere - Geräte fallen, wie z.B. sogenannte RTUs (Remote Terminal Units), intelligente Merging Units, Energiezähler, Energie- oder Leistungsmessgeräte, Power Meter zur Erfassung von Power-Quality Parametern und Fehlerrekorder.

Gemäß einer vorteilhaften Ausführungsform des erfindungsgemäßen Verfahrens ist vorgesehen, dass zur Ermittlung der Richtung des Fehlers bezüglich der Messstelle in dem Mittelspannungs-Energieversorgungsnetz von der Steuereinrichtung des Schutzgerätes ein durch die Phasenlage der Spannungsmesswerte in Bezug auf die Phasenlage der Strommesswerte gebildeter Phasenwinkel ausgewertet wird.

Auf diese Weise lässt sich besonders einfach, nämlich durch die bloße Betrachtung des zwischen den Strommesswerten und den Spannungsmesswerten eingeschlossenen Phasenwinkels, eine Erkennung der Fehlerrichtung durchführen. Dazu sind in dem elektrischen Schutzgerät üblicherweise Parameter abgespeichert, die Schwellenwerte definieren, bei deren Über- bzw.

Unterschreiten auf das Vorliegen einer bestimmten Fehlerrichtung geschlossen werden kann.

Bei dem erfindungsgemäßen Verfahren ist es möglich, die auf der Mittelspannungsseite erfassten Strommesswerte direkt mit den auf der Niederspannungsseite erfassten Spannungsmesswerten zu vergleichen und anhand geeigneter Kriterien eine entsprechende Fehlerrichtungserkennung vorzunehmen. Alternativ dazu kann jedoch auch vorgesehen sein, dass die auf der Niederspannungsseite des Transformators erfassten Spannungsmesswerte unter Heranziehung von Angaben über die Bauweise des Transformators zunächst in Hilfs-Spannungsmesswerte umgerechnet werden, die die Spannung auf der Mittelspannungsseite des Transformators charakterisieren, und dass zur Ermittlung der Richtung des Fehlers die Strommesswerte und die Hilfs-Spannungsmesswerte verwendet werden.

Auf diese Weise werden die auf der Niederspannungsseite erfassten Spannungsmesswerte zunächst in solche Hilfs-Spannungsmesswerte umgerechnet, die zumindest teilweise dieselben Eigenschaften aufweisen, wie sie Spannungsmesswerte aufweisen würden, die direkt auf der Mittelspannungsseite erfasst worden wären. Erst nach der Umrechnung wird eine Ermittlung der Fehlerrichtung durchgeführt.

Konkret kann in diesem Zusammenhang beispielsweise vorgesehen sein, dass unter Heranziehung von Angaben über die Schaltgruppe des Transformators aus den Spannungsmesswerten hinsichtlich ihrer jeweiligen Phasenlage umgerechnete Hilfs-Spannungsmesswerte ermittelt werden.

Die sogenannte Schaltgruppe eines Transformators gibt die Beschaltung der drei Phasen auf der Ober- und der Unterspannungsseite des Transformators an und ist durch die Bauart des Transformators festgelegt. Beispiele für übliche Verschaltungen sind eine Sternschaltung, eine Dreiecksschaltung oder eine Zickzackschaltung; die Verschaltungsarten können in beliebiger Weise miteinander kombiniert werden. Beispielsweise kann auf der Oberspannungsseite des Transformators eine Dreiecksschaltung vorgesehen sein, während auf der Unterspannungsseite des Transformators eine Sternschaltung vorliegt. Je nach Schaltgruppe des Transformators ergeben sich bei der Spannungstransformation unterschiedliche Phasenverschiebungen der einzelnen Phasenspannungen zwischen Ober- und Unterspannungsseite; der Wert der jeweiligen Phasenverschiebung ist durch die Schaltgruppe des Transformators jedoch eindeutig festgelegt. Daher kann bei Kenntnis der Schaltgruppe des Transformators auf die Phasenverschiebung zwischen den auf der Niederspannungsseite des Transformators erfassten Spannungsmesswerten und den auf der Mittelspannungsseite des Transformators vorliegenden Phasenspannungen geschlossen werden. Es ist damit in dieser Ausführungsform des Verfahrens möglich, die Hilfs-Spannungsmesswerte bezüglich ihrer Phasenlage entsprechend den auf der Mittelspannungsseite vorliegenden Phasenspannungen umzurechnen.

Da die Amplitude zur Ermittlung der Fehlerrichtung nicht unbedingt benötigt wird, kann sie im Rahmen der zuletzt genannten Ausführungsform bei der Umrechnung in die Hilfs-Spannungsmesswerte unberücksichtigt bleiben. Allerdings kann zusätzlich auch vorgesehen sein, dass unter Heranziehung von Angaben über das Übersetzungsverhältnis des Transformators auch die Amplitude der jeweiligen Hilfs-Spannungsmesswerte ermittelt wird.

Eine Umrechnung der Spannungsmesswerte nicht nur bezüglich ihrer Phasenlage, sondern auch bezüglich ihrer Amplitude durchzuführen, kann insbesondere dann von Interesse sein, wenn neben der Fehlerrichtungserkennung auch weitere Zusammenhänge zwischen den Strommesswerten und den Hilfs-Spannungsmesswerten ausgewertet werden sollen.

Konkret kann in diesem Zusammenhang beispielsweise vorgesehen sein, dass die Strommesswerte und die hinsichtlich ihrer Phasenlage und ihrer Amplitude umgerechneten Hilfs-Spannungsmesswerte auch zur Bestimmung einer Wirkleistung und/oder einer Scheinleistung und/oder einer Blindleistung an der Messstelle in dem Mittelspannungs-Energieversorgungsnetz verwendet werden.

Auf diese Weise können beispielsweise Angaben zu Lastflüssen oder zur Elektroenergiequalität an der Messstelle gemacht werden.

Gemäß einer vorteilhaften Ausführungsform des erfindungsgemäßen Verfahrens kann zudem vorgesehen sein, dass sowohl die Strommesswerte als auch die Spannungsmesswerte innerhalb einer den Transformator umfassenden Ortsnetzstation erfasst werden.

Solche Ortsnetzstationen werden üblicherweise in Mittelspannungsnetzen vorgesehen, um einerseits eine Transformation der Mittelspannung auf die für die elektrischen Verbraucher geeignete Niederspannungsebene vorzunehmen und andererseits einen Ausgangsknoten für die Verteilung der elektrischen Energie auf Niederspannungsebene an die elektrischen Verbraucher zu bilden. Üblicherweise umfasst eine Ortsnetzstation einen oder mehrere Transformatoren, die die Umwandlung der Mittelspannung in die Niederspannung vornehmen. Außerdem kann eine Ortsnetzstation Automatisierungsgeräte wie beispielsweise spezielle elektrische Schutzgeräte zur Erkennung einer Fehlerrichtung enthalten. In der hier beschriebenen Ausführungsform werden dem elektrischen Schutzgerät gemäß dem beschriebenen Verfahren die innerhalb einer Ortsnetzstation auf der Mittelspannungsseite des Transformators erfassten Strommesswerte und auf der Niederspannungsseite des Transformators erfassten Spannungsmesswerte zugeführt. Auf diese Weise kann innerhalb der Ortsnetzstation besonders vorteilhaft eine Entscheidung darüber getroffen werden, ob der Fehler in Vorwärtsrichtung, d. h. beispielsweise auf einem mehrere Ortsnetzstationen verbindenden Leitungsabschnitt des Mittelspannungs-Energieversorgungsnetzes, oder in Rückwärtsrichtung, d. h. beispielsweise auf einer Sammelschiene innerhalb der Ortsnetzstation, vorliegt.

Gemäß einer weiteren vorteilhaften Ausführungsform des erfindungsgemäßen Verfahrens ist vorgesehen, dass die erfassten Strom- und/oder Spannungsmesswerte daraufhin untersucht werden, hinsichtlich welcher Phasenleiter ein Fehler aufgetreten ist, dass in Abhängigkeit von den erkannten Phasenleitern eine Fehlerart des aufgetretenen Fehlers ermittelt wird, und dass in Abhängigkeit von der ermittelten Fehlerart diejenigen Strommesswerte und/oder Richtungserkennungskriterien ausgewählt werden, die für die Erkennung der Richtung des Fehlers herangezogen werden.

Bei dieser Ausführungsform des erfindungsgemäßen Verfahrens werden beispielsweise in geerdeten Netzen zunächst die erfassten Strommesswerte auf Erdschlüssen anzeigende Stromsprünge untersucht und in Abhängigkeit von den betroffenen Phasen wird auf die Fehlerart, also auf eine von dem Fehler betroffene Schleife, geschlossen. In ungeerdeten Netzen wird aus den erfassten Spannungsmesswerten eine Verlagerungsspannung bezüglich der jeweils fehlerbehafteten Phase berechnet und anhand der erkannten Spannungsverlagerung auf eine bestimmte Fehlerart geschlossen. Beispiele für verschiedene Fehlerarten sind ein Erdschluss zwischen jeweils einer Phase und Erde (Phase A - Erde, Phase B - Erde, Phase C - Erde), ein dreiphasiger Erdschluss (Phasen A, B, C - Erde), ein dreiphasiger Kurzschluss (Phasen A, B, C), ein Leiter-Leiter-Erdschluss (Phase A - Phase B - Erde, Phase B -Phase C - Erde, Phase C - Phase A - Erde) oder ein Leiter-Leiter-Kurzschluss (Phase A - Phase B, Phase B - Phase C, Phase C - Phase A). Entsprechend der jeweiligen Fehlerart können unterschiedliche Kriterien ("Richtungserkennungskriterien") herangezogen werden, um die Fehlerrichtung eindeutig zu erkennen. Richtungserkennungskriterien können insbesondere eine Angabe derjenigen Phasen von Strom und Spannung umfassen, zwischen denen die Phasenwinkel zur Ermittlung einer Vorwärts- oder Rückwärtsrichtung des Fehlers untersucht werden. Daher muss vor der Fehlerrichtungserkennung zuerst die Fehlerart des aufgetretenen Fehlers ermittelt und anhand der Fehlerart abschließend eine Auswahl getroffen werden, welche Richtungserkennungskriterien für die Erkennung der Fehlerrichtung herangezogen werden sollen.

Gemäß einer weiteren vorteilhaften Ausführungsform des erfindungsgemäßen Verfahrens ist vorgesehen, dass die erfassten Spannungsmesswerte kontinuierlich in einer Speichereinrichtung des Schutzgerätes abgespeichert werden und zur Ermittlung der Richtung eines dreiphasigen Fehlers diejenigen Spannungsmesswerte herangezogen werden, die unmittelbar vor Eintritt des Fehlers in der Speichereinrichtung abgespeichert worden sind.

Durch das Abspeichern der erfassten Spannungsmesswerte kann auch bei speziellen Fehlerarten, wie beispielsweise bei dreiphasigen Fehlern, eine Aussage über die Fehlerrichtung getroffen werden, da in diesem Fall sogenannte "Vorfehlerwerte" als Spannungsmesswerte herangezogen werden können, die im Gegensatz zu den im Fehlerfall komplett eingebrochenen Spannungen aller drei Phasen eine Phasenwinkelbestimmung bezüglich der entsprechenden Strommesswerte erlauben.

Hinsichtlich des Schutzgerätes wird die oben genannte Aufgabe durch ein elektrisches Schutzgerät zum Erkennen einer Richtung, in der ein Fehler in einem dreiphasigen elektrischen Mittelspannungs-Energieversorgungsnetz bezüglich einer Messstelle in dem Mittelspannungs-Energieversorgungsnetz aufgetreten ist, gelöst, wobei das Schutzgerät eine Steuereinrichtung aufweist, die dazu eingerichtet ist, zur Erkennung der Richtung des Fehlers sowohl phasenleiterbezogene Strommesswerte als auch phasenleiterbezogene Spannungsmesswerte heranzuziehen. Erfindungsgemäß ist vorgesehen, dass die Steuereinrichtung zur Durchführung eines Verfahrens gemäß einem der Ansprüche 1 bis 9 eingerichtet ist.

Die Erfindung wird im Folgenden anhand eines Ausführungsbeispiels näher erläutert. Hierzu zeigen
- Fig. 1: eine schematische Darstellung zweier Ortsnetzstationen zur Verbindung eines Mittelspannungs-Energieversorgungsnetzes mit Niederspannungs-Verteilnetzsträngen; und
- Fig. 2: eine schematische Darstellung eines elektrischen Schutzgerätes zum Erkennen der Richtung eines Fehlers in einem MittelspannungsEnergieversorgungsnetz.

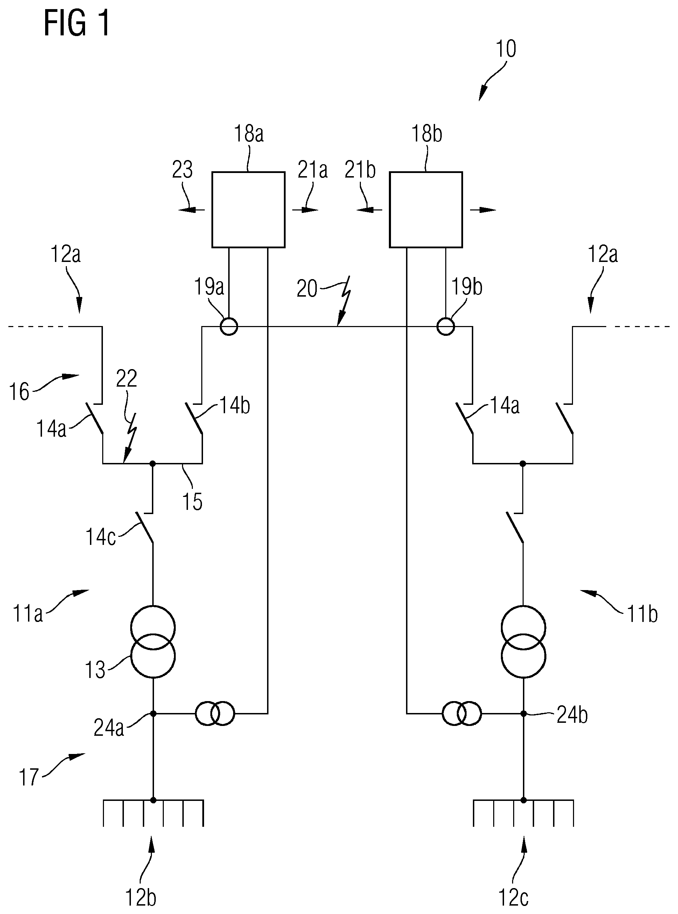

Fig. 1 zeigt eine Anordnung 10 mit einer ersten Ortsnetzstation 11a und einer zweiten Ortsnetzstation 11b. Die Ortsnetzstationen 11a und 11b sind im Wesentlichen gleich aufgebaut und dienen zur Verbindung eines dreiphasigen Mittelspannungs-Energieversorgungsnetzes 12a, das in Fig. 1 lediglich abschnittsweise angedeutet ist, mit Niederspannungs-Verteilnetzsträngen 12b und 12c, die in Fig. 1 ebenfalls lediglich beispielhaft angedeutet sind. Sowohl die Mittelspannungs- als auch die Niederspannungsebene sind in Fig. 1 in der sogenannten "Single-Line-Darstellung" gezeigt, in der durch eine einzige Linie alle drei Phasen angedeutet werden sollen.

Anhand der Ortsnetzstation 11a soll beispielhaft der Aufbau der Ortsnetzstationen 11a und 11b erläutert werden. Die Ortsnetzstation 11a umfasst einen Transformator 13, einen Mittelspannungs-Anschluss 16 zur Verbindung der Ortsnetzstation 11a mit dem Mittelspannungs-Energieversorgungsnetz 12a und einen Niederspannungs-Anschluss 17 zur Verbindung der Ortsnetzstation 11a mit dem Verteilnetzstrang 12b. Der Mittelspannungs-Anschluss 16 weist zudem Schalteinrichtungen 14a, 14b und 14c und eine Sammelschiene 15 auf. Außerdem umfasst die Ortsnetzstation 11a üblicherweise eine Schaltanlage zum Steuern und Überwachen der Funktionsweise der Ortsnetzstation 11a; der Übersichtlichkeit halber ist von einer solchen Schaltanlage nur ein Schutzgerät 18a gezeigt, mit dem - neben anderen Funktionen - eine Richtung erkannt werden kann, in der ein Fehler bezogen auf eine Messstelle 19a in dem Mittelspannungs-Energieversorgungsnetz liegt. Zur Erkennung der Fehlerrichtung zieht das Schutzgerät 18a phasenbezogene, also für jede der drei Phasen separat erfasste, Strom- und Spannungsmesswerte heran und untersucht die Messwerte gemäß unten näher erläuterten Richtungserkennungskriterien auf das Vorliegen eines Fehlers in Vorwärts- oder in Rückwärtsrichtung.

Die Ortsnetzstation 11b weist entsprechende Komponenten auf, insbesondere ein Schutzgerät 18b, das eine Fehlerrichtungserkennung bezogen auf eine Messstelle 19b vornimmt.

Um die Ortsnetzstationen 11a und 11b möglichst kostengünstig auszubilden und trotzdem eine zuverlässige Richtungserkennung hinsichtlich im Mittelspannungs-Energieversorgungsnetz aufgetretenen Fehlern vornehmen zu können, ist vorgesehen, dass lediglich die phasenbezogenen Strommesswerte an den Messstellen 19a bzw. 19b erfasst werden, während die phasenbezogenen Spannungsmesswerte an Messstellen 24a bzw. 24b aufgenommen werden, die auf der Niederspannungsseite der jeweiligen Ortsnetzstation 11a bzw. 11b angeordnet sind. Auf diese Weise können nämlich deutlich kleinere und kostengünstigere Spannungswandler für die Erfassung der Spannungsmesswerte eingesetzt werden, so dass die Ortsnetzstationen 11a bzw. 11b insgesamt mit deutlich geringeren Kosten aufgebaut werden können.

Beispielhaft ist in Fig. 1 ein erster Fehler 20 in Form eines Kurzschlusses oder eines Erdschlusses durch ein erstes Blitzsymbol angedeutet; dieser Fehler ist auf einer die beiden Ortsnetzstationen 12a und 12b verbindenden Leitung des Mittelspannungs-Energieversorgungsnetzes 12a aufgetreten. Üblicherweise wird die Fehlerrichtung in Schutzgeräten derart definiert, dass ein Fehler auf der primär überwachten Schutzzone, im vorliegenden Beispiel die Leitung zwischen den beiden Ortsnetzstationen, als in Vorwärtsrichtung liegend erkannt wird. Die Schutzgeräte 18a und 18b sind daher derart eingerichtet, dass sie den auf der Verbindungsleitung liegenden Fehler 20 jeweils in Vorwärtsrichtung erkennen sollen, die durch Pfeile 21a und 21b angedeutet wird.

Außerdem ist in Fig. 1 ein zweiter, durch ein Blitzsymbol angedeuteter Fehler 22 in Form eines Kurzschlusses oder Erdschlusses dargestellt, der auf der zwischen den Schalteinrichtungen 14a und 14b liegenden Sammelschiene 15 der Ortsnetzstation 11a aufgetreten ist. Diesen Fehler erkennt das Schutzgerät 18a entsprechend als in Rückwärtsrichtung liegend, wie es durch den Pfeil 23 angedeutet ist. Das Schutzgerät 18b erkennt auch diesen Fehler - bezogen auf die Messstelle 19b - in Vorwärtsrichtung.

Die Erkennung der jeweiligen Fehlerrichtung kann beispielsweise zur Ansteuerung von Schalteinrichtungen, z.B. der Schalter 14a, 14b und 14c verwendet werden, um die von dem jeweiligen Fehler betroffenen Abschnitte des Mittelspannungs-Energieversorgungsnetzes vom restlichen Energieversorgungsnetz abzutrennen. So kann der Fehler 20 durch Öffnen der Schalteinrichtung 14b der ersten Ortsnetzstation 11a sowie der Schalteinrichtung 14a der zweiten Ortsnetzstation 11b vom restlichen Mittelspannungs-Energieversorgungsnetz 12a abgetrennt werden, während der Niederspannungs-Verteilnetzstrang 12b über die geschlossenen Schalteinrichtungen 14a und 14c der ersten Ortsnetzstation 11a und der Niederspannungs-Verteilnetzstrang 12c über die geschlossenen Schalteinrichtungen 14b und 14c der zweiten Ortsnetzstation 11b weiter betrieben werden können. Hingegen muss der Fehler 22 auf der Sammelschiene 15 der ersten Ortsnetzstation 11a durch Öffnen aller diese Sammelschiene 15 begrenzenden Schalteinrichtungen 14a, 14b und 14c abgetrennt werden, wovon auch der Niederspannungs-Verteilnetzstrang 12b betroffen ist. Sofern hierbei eine phasenselektive Abtrennung stattfinden kann, d. h. dass bei Vorliegen eines lediglich einphasigen Erdschlusses nur die von dem Fehler tatsächlich betroffene Phase abgeschaltet wird, kann der Niederspannungs-Verteilnetzstrang 12b auch nach der Abschaltung des Fehlers 22 - zumindest eingeschränkt auf die nicht von dem Fehler betroffenen Phasen - weiter betrieben werden.

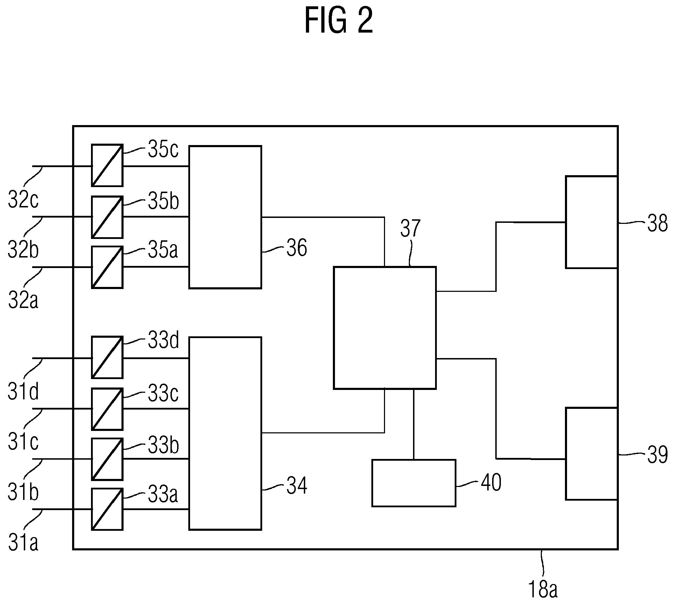

Die Funktionsweise der Richtungserkennung soll nachfolgend unter Hinzunahme der Fig. 2 erläutert werden, in der eine schematische Darstellung eines Schutzgerätes - beispielhaft sei das Schutzgerät 18a zur Erläuterung ausgewählt - gezeigt ist.

Über Strommesseingänge 31a, 31b, 31c werden dem Schutzgerät 18a die an der Messstelle 19a phasenbezogen erfassten Stromsignale zugeführt. Ein optionaler weiterer Strommesseingang 31b dient zur Zuführung eines Nullsystemsstroms, sofern ein entsprechender Stromwandler zur Erfassung des Nullsystemsstroms (beispielsweise ein sogenannter Umbauwandler) an der Messstelle 19a vorhanden ist. Über Spannungsmesseingänge 32a, 32b, 32c werden dem Schutzgerät 18a an der Messstelle 24a phasenbezogen erfasste Spannungssignale zugeführt.

Die phasenbezogenen Stromsignale werden über Messwerterfassungseinrichtungen 33a, 33b und 33c, die beispielsweise Sekundärstromwandler und Analog-Digital-Wandler zur Erzeugung entsprechender digitaler Strommesswerte umfassen, einer Messwert-Vorverarbeitungseinrichtung 34 zugeführt. Sofern über den Strommesswerteingang 31d ein Nullsystemstrom zugeführt wird, so wird auch dieser über eine entsprechende Messwert-Erfassungseinrichtung 33d der Messwert-Vorverarbeitungseinrichtung 34 zugeführt. Die Messwert-Vorverarbeitungseinrichtung 34 kann beispielsweise eine Filterung und/oder eine Verstärkung und eine Ermittlung von Amplitude und Phasenwinkel der Strommesswerte (beispielsweise im Rahmen einer Zeigerwertbildung) vornehmen.

Die an den Spannungsmesseingängen 32a, 32b und 32c zugeführten Spannungssignale werden über entsprechende Messwert-Erfassungseinrichtungen 35a, 35b und 35c einer Messwert-Vorverarbeitungseinrichtung 36 zugeführt. Die Messwert-Vorverarbeitungseinrichtung 36 kann beispielsweise eine Filterung und/oder Verstärkung und eine Ermittlung von Amplitude und Phasenwinkel der Spannungs-Messwerte vornehmen. Ebenso kann die Messwert-Vorverarbeitungseinrichtung 36 bei Bedarf eine Umrechnung der auf der Niederspannungsseite des Transformators 13 erfassten Spannungsmesswerte unter Heranziehung von Angaben über die Bauweise des Transformators 13 vornehmen. Dieser Punkt wird weiter unten näher erläutert.

Das Schutzgerät 18a weist weiterhin eine Steuereinrichtung 37, beispielsweise einen Mikroprozessor, auf, die unter Verwendung der Strommesswerte und der Spannungsmesswerte eine Entscheidung darüber trifft, ob ein in dem Mittelspannungs-Energieversorgungsnetz aufgetretener Fehler bezogen auf die Messstelle 19a in einer Vorwärts- bzw. Rückwärtsrichtung vorliegt. Das Ergebnis der Untersuchung kann als Richtungssignal beispielsweise einem Steuerausgang 38 zugeführt werden, der beispielsweise zur Ansteuerung der Schalteinrichtungen 14a, 14b und/oder 14c eingerichtet ist. Dazu kann der Steuerausgang elektrische und/oder optische Signalausgänge bereitstellen. Eine Information über die Fehlerrichtung kann außerdem über eine Kommunikationseinrichtung 39 des Schutzgerätes 18a, beispielsweise über eine Modbus-Schnittstelle, an ein entsprechendes Kommunikationssystem weitergegeben werden, um den Betreiber des Mittelspannungs-Energieversorgungsnetzes über den Fehler und die entsprechende Fehlerrichtung zu informieren. Hierzu kann die abgegebene Information beispielsweise einer Netzleitstelle zugeführt werden.

Die Steuereinrichtung 37 des Schutzgerätes 18a kann derart eingerichtet sein, dass sie eine Entscheidung über die Fehlerrichtung anhand eines Phasenwinkels trifft, der durch die Phasenlage der Spannungsmesswerte im Vergleich zu einer Phasenlage der Strommesswerte gebildet wird. Generell wird hierfür derjenige Phasenwinkel ausgewertet, der zwischen dem Stromzeiger einer von dem Fehler betroffenen Phase und einem Spannungszeiger gebildet wird, wobei der heranzuziehende Spannungszeiger durch ein von der Fehlerart abhängiges Richtungskriterium angegeben wird. Liegt der ermittelte Phasenwinkel zwischen 0° und 180°, so wird auf einen Fehler in Vorwärtsrichtung geschlossen, während bei einem Phasenwinkel zwischen 180° und 360° auf einen in Rückwärtsrichtung liegenden Fehler geschlossen wird. In der Praxis müssen von den jeweiligen Winkelbereichsgrenzen zur Beurteilung des Phasenwinkels von der Messgenauigkeit der eingesetzten Wandler abhängige Toleranzwerte abgezogen werden. Diese Toleranzwerte liegen beispielsweise bei etwa 2°, so dass bei diesem Beispiel letztlich für einen Vorwärtsfehler ein Phasenwinkel zwischen 2° und 178° und für einen Rückwärtsfehler ein Phasenwinkel zwischen 182° und 358° gültig ist.

Dabei kann die Steuereinrichtung 37 beispielsweise die auf der Niederspannungsseite 34 erfassten Spannungsmesswerte direkt zum Vergleich mit den Strommesswerten heranziehen und anhand als Parameter abgespeicherter Richtungserkennungskriterien eine Entscheidung über die Fehlerrichtung treffen.

Bei direkter Verwendung der auf der Niederspannungsseite gemessenen Spannungsmesswerte müssen die Bereichsgrenzen der Phasenwinkel für die jeweiligen Fehlerrichtungen durch einen von der Bauart des Transformators abhängigen Korrekturwinkel angepasst werden, um den durch die Transformation erzeugten Phasenwinkelversatz zu kompensieren. Die folgende Tabelle A gibt für das Beispiel eines Transformators in der Verschaltung Dyn 11 Richtungskriterien an, die einerseits den als Bezugs-Strommesswert zu betrachtenden Stromzeiger und andererseits einen zu betrachtenden Spannungszeiger benennen. Ein etwaiger zu verwendender Wert zur Korrektur der Phasenwinkelbereichsgrenzen wird jeweils in der Spalte der Spannungszeiger in Klammern mit angegeben.

**Tabelle A:**

| | Fehler auf Phase A | | Fehler auf Phase B | | Fehler auf Phase C | |
|---|---|---|---|---|---|---|
| Fehlerart | Bezugsstrom | Spannung | Bezugsstrom | Spannung | Bezugsstrom | Spannung |
| Phase A-Erde | I_{A} | V_{b} (+90°) oder V_{ac} (0°) | -- | -- | -- | -- |
| Phase B-Erde | -- | -- | I_{B} | V_{c} (+90°) oder (0°) | -- | -- |
| Phase C-Erde | -- | -- | -- | -- | I_{C} | Vₐ (+90°) oder V_{cb} (0°) |
| Phase A-Phase B | I_{A} | V_{b} (+90°) oder V_{bc} (+90°) | I_{B} | V_{c} (+90°) oder V_{ca} (+90°) | -- | -- |
| Phase B-Phase C | -- | -- | I_{B} | V_{c} (+90°) oder V_{ca} (+90°) | I_{C} | Vₐ V_{ca} (+90°) oder V_{ab} (+90° ) |
| Phase C-Phase A | I_{A} | V_{b} (+90°) oder V_{bc} V_{ca} (+90°) | -- | -- | I_{C} | Vₐ V_{ca} (+90°) oder V_{ab} (+90° ) |
| Phase A-Phase B-Erde | I_{A} | V_{b} (+90°) oder V_{bc} V_{ca} (+90°) | I_{B} | V_{c} (+90°) oder V_{ca} V_{ca} (+90°) | -- | -- |
| Phase B-Phase C Erde | -- | -- | I_{B} | V_{c} V_{ca} (+90°) oder V_{ca} (+90°) | I_{C} | Vₐ V_{ca} (+90°) oder V_{ab} (+90° ) |
| Phase C-Phase A-Erde | I_{A} | V_{b} (+90°) oder V_{bc} V_{ca} (+90°) | -- | -- | I_{C} | Vₐ (+90°) oder V_{ab} (+90°) |
| Phase A-Phase B-Phase C | I_{A} | V_{b} (+90°) oder V_{ac} (0°) | I_{B} | V_{c} (+90°) oder V_{ba} (0°) | I_{C} | Vₐ (+90°) oder V_{cb} (0°) |
| Phase A-Phase B-Phase C-Erde | I_{A} | V_{b} (+90°) oder V_{ac} (0°) | I_{B} | V_{c} (+90°) oder V_{ba} (0°) | I_{C} | Vₐ (+90°) oder V_{cb} (0°) |

Tabelle A zeigt die in Abhängigkeit von der Fehlerart und der betroffenen Phase zu verwendenden Bezugs-Strommesswerte (diejenigen Strommesswerte, die für die Ermittlung des Phasenwinkels herangezogen werden) und die zur Erkennung der Fehlerrichtung (vorwärts, rückwärts) jeweils anzusetzenden Spannungsmesswerte mit den jeweils zu verwendenden Korrekturwerten für die Phasenwinkelbereichsgrenzen. Dabei steht I für den Strom, V für die Spannung und die Indizes A, B, C bezeichnen die jeweiligen Phasenleiter der Mittelspannungsseite, während die Indizes a, b, c die Phasenleiter auf die Niederspannungsseite angeben. So werden beispielsweise gemäß Tabelle A für einen einphasigen Fehler zwischen der Phase A und Erde als Basis für die Ermittlung der Fehlerrichtung die für die Phase A erfassten Strommesswerte sowie die für die Phase b (auf der Niederspannungsseite) erfassten Spannungsmesswerte zuzüglich eines Korrekturwertes von 90° für den Phasenwinkel zugrunde gelegt. Sofern mehrere Spalten der Tabelle für eine Fehlerart ausgefüllt sind, sind die dort aufgeführten Richtungserkennungskriterien logisch mit "ODER" verknüpft zu betrachten.

Alternativ kann auch vorgesehen sein, dass die Spannungsmesswerte, beispielsweise in der Steuereinrichtung 37 oder in der Messwert-Vorverarbeitungseinrichtung 36, zunächst in Hilfs-Spannungsmesswerte umgerechnet werden, die den in Tabelle A angegebenen Korrekturwinkel direkt beinhalten, wobei auch hier für die Umrechnung Angaben über die Bauweise des Transformators 13 herangezogen werden.

Wenn die Steuereinrichtung 37 die Entscheidung über die Fehlerrichtung anhand lediglich der Phasenwinkelinformationen der Strommesswerte und der Spannungsmesswerte trifft, so ist es ausreichend, anhand der Schaltgruppe des Transformators 13 die Phasenverschiebung zu bestimmen, die bei der Transformation der auf der Oberspannungsseite des Transformators 13 anliegenden Mittelspannung in die auf der Unterspannungsseite des Transformators 13 vorliegende Niederspannung auftritt. Dabei gibt die Schaltgruppe des Transformators eindeutig die vorhandene Phasenverschiebung an, so dass mit der Information über die Schaltgruppe aus den auf der Niederspannungsseite erfassten Spannungsmesswerten eindeutig die Phasenlage der Hilfs-Spannungsmesswerte berechnet werden kann. Die auf diese Art und Weise berechnete Phasenlage der Hilfs-Spannungsmesswerte entspricht folglich der Phasenlage der auf der Mittelspannungsseite vorhandenen Spannung. Wenn außerdem durch die Steuereinrichtung 37 auch andere, die elektrische Energie auf der Mittelspannungsseite angebende Parameter, wie beispielsweise eine Wirk-, eine Blind- oder ein Scheinleistung, sowie der exakte Wert der auf der Mittelspannungsseite vorliegenden Spannung berechnet werden sollen, beispielsweise um mit dem Schutzgerät 18a für die Messstelle 19a gleichzeitig eine Überwachung der Elektroenergiequalität gemäß der Norm EN 50160 vornehmen zu können, bietet es sich an, dass die Spannungsmesswerte auch bezüglich ihrer Amplitude in entsprechende Hilfs-Spannungsmesswerte umgerechnet werden, wobei hierzu zusätzlich das Übersetzungsverhältnis des Transformators 13 heranzuziehen ist. Bei Kenntnis der Schaltgruppe und des Übersetzungsverhältnisses des Transformators 13 lassen sich folglich die auf der Niederspannungsseite des Transformators 13 gemessenen Spannungsmesswerte eindeutig in der Spannung auf der Mittelspannungsseite des Transformators 13 entsprechende Hilfs-Spannungsmesswerte umrechnen.

Die Steuereinrichtung 37 des Schutzgerätes 18a kann derart ausgebildet sein, dass sie anhand von Stromsprüngen der Strommesswerte bzw. auftretenden Verlagerungsspannungen, die anhand der Spannungsmesswerte oder der Hilfs-Spannungsmesswerte ermittelt werden können, zunächst erkennt, bezüglich welcher Phase ein Fehler aufgetreten ist und hieraus eine Information über die Fehlerart ableitet. Abhängig von der Fehlerart werden anschließend von der Steuereinrichtung 37 die zum Vergleich zugrunde zu legenden Strommesswerte sowie die anzusetzenden Richtungserkennungskriterien für die Erkennung der Fehlerrichtung z.B. anhand der Tabelle A ausgewählt.

Das Schutzgerät 18a weist darüber hinaus eine Speichereinrichtung 40 auf, bei der es sich beispielsweise um einen Ringspeicher handeln kann, in dem die erfassten Strom- und Spannungsmesswerte für eine bestimmte Zeit abgelegt werden können. Sofern ein dreiphasiger Fehler vorliegt, müssen für die Erkennung der Fehlerrichtung sogenannte Vorfehler-Spannungsmesswerte herangezogen werden, d. h. dass der Vergleich mit den entsprechenden Strommesswerten anhand derjenigen Strommesswerte stattfindet, die unmittelbar vor Eintritt des Fehlers an der Messstelle 24a erfasst und in der Speichereinrichtung abgespeichert worden sind. Hinsichtlich der Strommesswerte werden die während des Fehlers erfassten Strommesswerte angesetzt.

## Patentansprüche

1. Verfahren zum Erkennen einer Richtung, in der ein Fehler in einem dreiphasigen elektrischen Mittelspannungs-Energieversorgungsnetz (12a) bezüglich einer Messstelle (19a, 19b) in dem Mittelspannungs-Energieversorgungsnetz (12a) aufgetreten ist, bei dem von einer Steuereinrichtung (37) eines elektrischen Schutzgerätes (18a, 18b) zur Erkennung der Richtung des Fehlers sowohl phasenleiterbezogene Strommesswerte als auch phasenleiterbezogene Spannungsmesswerte herangezogen werden, wobei die Strommesswerte an der Messstelle (19a, 19b) in dem Mittelspannungs-Energieversorgungsnetz (12a) erfasst werden;
**dadurch gekennzeichnet, dass**
- die Spannungsmesswerte auf der Niederspannungsseite eines das Mittelspannungs-Energieversorgungsnetz (12a) mit einem Niederspannungs-Energieversorgungsnetz verbindenden Transformators (13) erfasst werden.

2. Verfahren nach Anspruch 1,
**dadurch gekennzeichnet, dass**
- zur Ermittlung der Richtung des Fehlers bezüglich der Messstelle (19a, 19b) in dem Mittelspannungs-Energieversorgungsnetz (12a) von der Steuereinrichtung (37) des Schutzgerätes (18a, 18b) ein durch die Phasenlage der Spannungsmesswerte in Bezug auf die Phasenlage der Strommesswerte gebildeter Phasenwinkel ausgewertet wird.

3. Verfahren nach Anspruch 1 oder 2,
**dadurch gekennzeichnet, dass**
- die auf der Niederspannungsseite des Transformators (13) erfassten Spannungsmesswerte unter Heranziehung von Angaben über die Bauweise des Transformators (13) zunächst in Hilfs-Spannungsmesswerte umgerechnet werden, die die Spannung auf der Mittelspannungsseite des Transformators (13) charakterisieren; und
- zur Ermittlung der Richtung des Fehlers die Strommesswerte und die Hilfs-Spannungsmesswerte verwendet werden.

4. Verfahren nach Anspruch 3,
**dadurch gekennzeichnet, dass**
- unter Heranziehung von Angaben über die Schaltgruppe des Transformators (13) aus den Spannungsmesswerten hinsichtlich ihrer jeweiligen Phasenlage umgerechnete Hilfs-Spannungsmesswerte ermittelt werden.

5. Verfahren nach Anspruch 4,
**dadurch gekennzeichnet, dass**
- unter Heranziehung von Angaben über das Übersetzungsverhältnis des Transformators (13) auch die Amplitude der jeweiligen Hilfs-Spannungsmesswerte ermittelt wird.

6. Verfahren nach Anspruch 5,
**dadurch gekennzeichnet, dass**
- die Strommesswerte und die hinsichtlich ihrer Phasenlage und ihrer Amplitude umgerechneten Hilfs-Spannungsmesswerte auch zur Bestimmung einer Wirkleistung und/oder einer Scheinleistung und/oder einer Blindleistung an der Messstelle (19a, 19b) in dem Mittelspannungs-Energieversorgungsnetz (12a) verwendet werden.

7. Verfahren nach einem der vorangehenden Ansprüche, **dadurch gekennzeichnet, dass**
- sowohl die Strommesswerte als auch die Spannungsmesswerte innerhalb einer den Transformator (13) umfassenden Ortsnetzstation (11a, 11b) erfasst werden.

8. Verfahren nach einem der vorangehenden Ansprüche, **dadurch gekennzeichnet, dass**
- die erfassten Strom- und/oder Spannungsmesswerte daraufhin untersucht werden, hinsichtlich welcher Phasenleiter ein Fehler aufgetreten ist;
- in Abhängigkeit von den erkannten Phasenleitern eine Fehlerart des aufgetretenen Fehlers ermittelt wird; und
- in Abhängigkeit von der ermittelten Fehlerart diejenigen Strommesswerte und/oder Richtungserkennungskriterien ausgewählt werden, die für die Erkennung der Richtung des Fehlers herangezogen werden.

9. Verfahren nach einem der vorangehenden Ansprüche,
**dadurch gekennzeichnet, dass**
- die erfassten Spannungsmesswerte kontinuierlich in einer Speichereinrichtung (40) des Schutzgerätes (18a, 18b) abgespeichert werden und zur Ermittlung der Richtung eines dreiphasigen Fehlers diejenigen Spannungsmesswerte herangezogen werden, die unmittelbar vor Eintritt des Fehlers in der Speichereinrichtung (40) abgespeichert worden sind.

10. Elektrisches Schutzgerät (18a, 18b) zum Erkennen einer Richtung, in der ein Fehler in einem dreiphasigen elektrischen Mittelspannungs-Energieversorgungsnetz (12a) bezüglich einer Messstelle (19a, 19b) in dem Mittelspannungs-Energieversorgungsnetz (12a) aufgetreten ist, mit einer Steuereinrichtung (37), die dazu eingerichtet ist, zur Erkennung der Richtung des Fehlers sowohl phasenleiterbezogene Strommesswerte als auch phasenleiterbezogene Spannungsmesswerte heranzuziehen,
**dadurch gekennzeichnet, dass**
- die Steuereinrichtung (37) zur Durchführung eines Verfahrens gemäß einem der Ansprüche 1 bis 9 eingerichtet ist.

## Claims

1. Method for detecting a direction in which a fault has occurred in a three-phase electrical medium voltage power supply network (12a) with respect to a metering point (19a, 19b) in the medium voltage power supply network (12a), in which method both phase conductor-related current measured values and phase conductor-related voltage measured values are used by a control device (37) of an electrical protective device (18a, 18b) to detect the direction of the fault, wherein the current measured values are detected at the metering point (19a, 19b) in the medium voltage power supply network (12a);
**characterised in that**
- the voltage measured values are detected on the low voltage side of a transformer (13) connecting the medium voltage power supply network (12a) to a low voltage power supply network.

2. Method according to claim 1,
**characterised in that**
- to establish the direction of the fault with respect to the metering point (19a, 19b) in the medium voltage power supply network (12a) a phase angle formed by the phase position of the voltage measured values in relation to the phase position of the current measured values is evaluated by the control device (37) of the protective device (18a, 18b).

3. Method according to claim 1 or 2,
**characterised in that**
- the voltage measured values detected on the low voltage side of the transformer (13) are initially converted into auxiliary voltage measured values by employing specifications about the construction of the transformer (13) which characterise the voltage on the medium voltage side of the transformer (13); and
- the current measured values and the auxiliary voltage measured values are used to establish the direction of the fault.

4. Method according to claim 3,
**characterised in that**,
- by employing specifications about the switching group of the transformer (13), converted auxiliary voltage measured values are established from the voltage measured values in respect of their phase position in each case.

5. Method according to claim 4,
**characterised in that**,
- by employing specifications about the transformation ratio of the transformer (13), the amplitude of the respective auxiliary voltage measured values is also established.

6. Method according to claim 5,
**characterised in that**
- the current measured values and the auxiliary voltage measured values converted in respect of their phase position and their amplitude are also used for determining an effective power and/or an apparent power and/or a reactive power at the metering point (19a, 19b) in the medium voltage power supply network (12a).

7. Method according to one of the preceding claims,
**characterised in that**
- both the current measured values and also the voltage measured values are detected within a local network station (11a, 11b) including the transformer (13).

8. Method according to one of the preceding claims,
**characterised in that**
- the detected current and/or voltage measured values are investigated to establish the phase conductor in respect of which a fault has occurred;
- as a function of the detected phase conductors a fault type of the fault which has occurred is established; and
- as a function of the fault type established, those current measured values and/or direction detection criteria are selected which will be employed for the detection of the direction of the fault.

9. Method according to one of the preceding claims,
**characterised in that**
- the detected voltage measurement values are stored continuously in a memory device (40) of the protective device (18a, 18b) and, to establish the direction of a three-phase fault, those voltage measured values are employed which have been stored in the memory device (40) immediately before the occurrence of the fault.

10. Electrical protective device (18a, 18b) for detecting a direction in which a fault has occurred in a three-phase electrical medium voltage power supply network (12a) with respect to a metering point (19a, 19b) in the medium voltage power supply network (12a), with a control device (37) which is equipped to use both phase conductor-related current measured values and also phase conductor-related voltage measured values for detecting the direction of the fault,
**characterised in that**
- the control device (37) is configured for carrying out the method according to one of claims 1 to 9.

## Revendications

1. Procédé de détection d'un sens dans lequel un défaut est apparu dans un réseau (12a) d'alimentation en énergie électrique de moyenne tension triphasé par rapport à un point (19a, 19b) de mesure du réseau (12a) d'alimentation en énergie de moyenne tension, dans lequel, par un dispositif ( 37 ) de commande d'un appareil ( 18a, 18b ) électrique de protection pour la détection du sens du défaut, on tire parti à la fois de valeurs de mesure du courant se rapportant à un conducteur de phase et de valeurs de mesure de la tension se rapportant à un conducteur de phase, les valeurs de mesure du courant étant relevées au point (19a, 19b ) de mesure du réseau ( 12a ) d'alimentation en énergie de moyenne tension,
**caractérisé en ce que**
- on relève les valeurs de tension du côté de la basse tension d'un transformateur ( 13 ) reliant le réseau (12a) d'alimentation en énergie de moyenne tension à un réseau d'alimentation en énergie de basse tension.

2. Procédé suivant la revendication 1,
**caractérisé en ce que**
pour déterminer le sens du défaut par rapport au point ( 19a, 19b ) de mesure du réseau ( 12a ) d'alimentation en énergie de moyenne tension, on exploite, par le dispositif ( 37 ) de commande de l'appareil ( 18a, 18b ) de protection, un angle de phase formé par la position en phase des valeurs de mesure de tension par rapport à la position en phase des valeurs de mesure de courant.

3. Procédé suivant la revendication 1 ou 2,
**caractérisé en ce que**
- on transforme par le calcul les valeurs de mesure de tension relevées du côté basse tension du transformateur ( 13 ), en tirant partie d'indications sur le mode de construction du transformateur ( 13 ), d'abord en valeurs de mesure de tension auxiliaires, qui caractérisent la tension du côté de la tension moyenne du transformateur ( 13 ) et
- pour déterminer le sens du défaut, on utilise les valeurs de mesure du courant et les valeurs de mesure de tension auxiliaires.

4. Procédé suivant la revendication 3,
**caractérisé en ce que**
- en tirant partie d'indications sur le couplage du transformateur ( 13 ), on détermine, à partir des valeurs de mesure de tension, des valeurs de mesure de tension auxiliaires transformées par le calcul en ce qui concerne leur position en phase respective.

5. Procédé suivant la revendication 4,
**caractérisé en ce que**
- en tirant partie d'indications sur le rapport de transformation du transformateur ( 13 ), on détermine également l'amplitude des valeurs de mesure de tension auxiliaires respectives.

6. Procédé suivant la revendication 5,
**caractérisé en ce que**
- on utilise les valeurs de mesure de courant et des valeurs de mesure de tension auxiliaires transformées par le calcul en ce qui concerne leur position en phase et leur amplitude, et également pour la détermination d'une puissance effective et/ou d'une puissance apparente et/ou d'une puissance réactive au point (19a, 19b ) de mesure du réseau (12a) d'alimentation en énergie de moyenne tension.

7. Procédé suivant l'une des revendications précédentes,
**caractérisé en ce que**
- on relève à la fois des valeurs de mesure de courant et les valeurs de mesure de tension dans un poste ( 11a, 11b ) de réseau local comprenant le transformateur ( 13 ).

8. Procédé suivant l'une des revendications précédentes,
**caractérisé en ce que**
- on étude les valeurs de mesure relevées de courant et/ou de tension pour connaître le conducteur de phase où un défaut est apparu,
- en fonction des conducteurs de phase détectés, on détermine un type du défaut qui est apparu et, en fonction du type de défaut déterminé, on sélectionne les valeurs de mesure de courant et/ou des critères de détection de sens, qui sont mis à profit pour la détection du sens du défaut.

9. Procédé suivant l'une des revendications précédentes,
**caractérisé en ce que**
- on mémorise les valeurs de mesure de tension relevées continuellement dans un dispositif ( 40 ) de mémorisation de l'appareil ( 18a, 18b ) de protection et, pour la détermination du sens d'un défaut triphasé, on tire partie des valeurs de mesure de tension, qui ont été mémorisées dans le dispositif ( 40 ) de mémoire juste avant l'entrée du défaut.

10. Appareil ( 18a, 18b ) de protection électrique pour la détection d'un sens dans lequel un défaut est apparu dans un réseau ( 12a ) d'alimentation en énergie électrique de moyenne tension triphasé par rapport à un point ( 19a, 19b ) de mesure du réseau (12a) d'alimentation en énergie de moyenne tension, comprenant un dispositif ( 37 ) de commande qui est agencé pour tirer parti, pour détecter le sens du défaut, à la fois de valeurs de mesure de courant se rapportant à un conducteur de phase et des valeurs de mesure de tension se rapportant à un conducteur de phase,
**caractérisé en ce que**
le dispositif ( 37 ) de commande est agencé pour effectuer un procédé suivant l'une des revendications 1 à 9.
